# EUROPEAN PATENT APPLICATION

(11) **EP 0 738 003 A2**
(43) Date of publication of application: **16.10.1996**
(21) Application number: 96105727.0
(22) Date of filing: 11.04.1996
(51) Int. Cl.: H01L 21/316, C23C 16/40

(54) **Method of forming silicon oxide layer for semiconductor devices using low pressure chemical vapor deposition (LPCVD)**

(30) Priority: 12.04.1995 JP 86843/95
(71) Applicant: MATSUSHITA ELECTRIC INDUSTRIAL CO., LTD., Kadoma-shi, Osaka-fu, 571 (JP)
(72) Inventor: Sugiyama, Tatsuo, Osaka-shi, Osaka 536 (JP); Yano, Kousaku, Katano-shi, Osaka 576 (JP)
(74) Representative: Grünecker, Kinkeldey, Stockmair & Schwanhäusser Anwaltssozietät

(57) **Abstract**

A premise for a method of forming a silicon oxide film is to use a low pressure CVD method in which silane gas and nitrous oxide gas are used as principal materials. A deposition condition is that a deposition temperature is 800°C or lower, a gas pressure of the principal materials is 150 Pa or smaller, and a gas flow rate of the principal materials is 0.018 liter/min or smaller per 1 liter of capacity of a reaction chamber under a standard condition of 25°C at one atmospheric pressure.

## Description

### BACKGROUND OF THE INVENTION

The present invention relates to a method of forming a silicon oxide film which is used in a semiconductor device such as a VLSI by utilizing a low pressure CVD (chemical vapor deposition) method, and also to a method of manufacturing a semiconductor device using the method of forming a silicon oxide film.

As a method of forming a silicon oxide film which is used in a semiconductor device such as a VLSI, a low pressure CVD method, an atmospheric pressure CVD method and a plasma CVD method are known.

When aluminum is used as a wire material, since the melting point of aluminum is as low as 660°C, an atmospheric pressure CVD method, a plasma CVD method and the like are often used in which deposition of a film is possible at a low temperature near 400°C.

However, a silicon oxide film which is formed by a low pressure CVD method is superior to a silicon oxide film which is formed by an atmospheric pressure CVD method, a plasma CVD method or the like in terms of density and purity. Hence, it is desirable to use a silicon oxide film which is formed by a low pressure CVD method, as an insulating film for a gate electrode or as a side-wall for a gate electrode and the like.

Silicon oxide films are classified into LTO (Low Temperature Oxide) films which are deposited at a low temperature about 400°C by an atmospheric pressure CVD method, a plasma CVD method or the like and HTO (High Temperature Oxide) films which are deposited at a high temperature from 700 to 850°C by a low pressure CVD method. Hence, in the following description, a silicon oxide film which is formed by an atmospheric pressure CVD method, a plasma CVD method or the like will be referred to as an LTO film, whereas a silicon oxide film which is formed by a low pressure CVD method will be referred to as a HTO film.

For forming an HTO film, a method using silane (SiH₄) gas and nitrous oxide (N₂O) gas as principal materials and a method using tetraethoxysilicate (Si(OC₂H₅)₄; hereinafter referred to a TEOS), i.e., organic gas, and oxygen or ozone-contained oxygen are known.

By the way, in recent years, since a semiconductor device is desired to operate at a higher speed and low consumption power, a further increase in the integration and the density of a VLSI is demanded. To meet this demand, it is necessary to control a diffusion profile of an impurity more accurately so that a deterioration in the performance and the reliability of a transistor is prevented. From this point of view, during a step of forming a silicon oxide film by a low pressure CVD method, it is necessary to decrease a deposition temperature and reduce a deposition time.

Since the method using TEOS allows to deposit a silicon oxide film at a deposition temperature of about 700°C and a deposition speed of about 6 to 7 nm/min, this method is superior to the method which uses silane gas, in terms of a decrease in a temperature during processes and ease of mass production. Hence, a low pressure CVD method using TEOS is often used in manufacturing processes for manufacturing a semiconductor device such as a VLSI.

However, a low pressure CVD method using TEOS has the following problems.

First, since the coefficient of contraction of an HTO film is high, thermal processing at about 900°C to activate an impurity creates a crack in the HTO film in some cases. Such a crack serves as a cause of stripping off of the film and a deterioration in insulation performance, and hence, reduces the yield.

Second, a large quantity of reaction byproducts adhere to an inner wall of an exhaustion duct pipe. This is because an intermediate product which is created by TEOS and thermal decomposition of TEOS tends to gets liquefied or aggregates within the exhaustion duct pipe which remains at a lower temperature than a reaction pipe. The byproducts adhered to the inner wall of the exhaustion duct pipe results in dusts or clogs the exhaustion duct pipe, and therefore, a maintenance cycle becomes extremely short.

In this manner, a low pressure CVD method using TEOS has a problem that the yield is greatly reduced and a cost for maintaining a device is increased.

For this reason, a low pressure CVD method using silane gas is preferred to form a silicon oxide film during manufacturing processes for manufacturing a semiconductor device such as a VLSI.

In this case, it is necessary to form a silicon oxide film with a uniform thickness to improve the yield. However, a silicon oxide film which is formed by a conventional low pressure CVD method using silane gas is not satisfactory with respect to the uniformness of the film thickness, which is a first problem.

Further, while a deposition temperature is conventionally 820°C or higher since a deposition speed is slow in a low pressure CVD method using silane gas, when a deposition temperature is 820°C or higher, it is impossible to accurately control a diffusion profile of an impurity. Therefore, to accurately control a diffusion profile of an impurity, it is necessary to form a silicon oxide film at 800°C or a lower temperature and in a short deposition time. However, if a deposition temperature is set at 800°C or at a lower temperature in a conventional low pressure CVD method using silane gas, a deposition time must be increased. Due to this constraint, it is still impossible to accurately control a diffusion profile of an impurity, which is a second problem.

### SUMMARY OF THE INVENTION

The present invention has been made to solve these problems. Accordingly, in a method of forming a silicon oxide film by a low pressure CVD method using silane gas, a first object of the present invention is to form a silicon oxide film with a uniform thickness, and a second object of the present invention is to accurately control diffusion of an impurity in a semiconductor substrate.

To attain the first object above, a first method of forming a silicon oxide film according to the present invention comprises a silicon oxide film depositing step of depositing a silicon oxide film by a low pressure CVD method in which silane gas and nitrous oxide gas are used as principal materials, and the silicon oxide film depositing step is performed under a deposition condition that a deposition temperature is 800°C or lower and a gas flow rate of the principal materials is 0.018 liter/min or smaller per 1 liter of capacity of a reaction chamber under a standard condition of 25°C at one atmospheric pressure.

In the first method of forming a silicon oxide film, when the deposition temperature is 800°C and the gas flow rate of the principal materials is 0.018 liter/min per 1 liter of capacity of the reaction chamber under the standard condition, the uniformness of the film thickness of a resultant silicon oxide film reaches a limit of a tolerance range. Since collision between reaction products (deposits) becomes less frequent as the deposition temperature becomes lower than 800°C, the uniformness of the film thickness of a silicon oxide film is improved. If the deposition temperature is equal to or lower than 800°C, the uniformness of the film thickness of a silicon oxide film stays within the tolerance range. Further, when the gas flow rate of the principal materials becomes smaller than 0.018 liter/min per 1 liter of capacity of the reaction chamber under the standard condition, a flow of gas within the reaction chamber becomes more like a laminar flow, which makes it difficult for the gas to swirl between wafers. Since this improves the uniformness of the film thickness of a silicon oxide film which is deposited on a wafer, if the gas flow rate of the principal materials is 0.018 liter/min or smaller, the uniformness of the film thickness of the silicon oxide film stays within the tolerance range. Hence, the uniformness of the film thickness of the silicon oxide film which is obtained is improved.

In the first method of forming a silicon oxide film, the deposition condition preferably includes a condition which causes a gas pressure of the principal materials to become equal to or smaller than 170 Pa. This ensures that the uniformness of the film thickness of a silicon oxide film which is obtained stays within the tolerance range of 4% or smaller.

In the first method of forming a silicon oxide film, the deposition condition preferably includes a condition which causes a gas pressure of the principal materials to become equal to or smaller than 125 Pa. This ensures that the uniformness of the film thickness of a silicon oxide film obtained is ideally 3% or smaller.

To attain the second object above, a second method of forming a silicon oxide film according to the present invention comprises a silicon oxide film depositing step of depositing a silicon oxide film by a low pressure CVD method in which silane gas and nitrous oxide gas are used as principal materials, and the silicon oxide film depositing step is performed under a deposition condition that a deposition temperature is 800°C or lower and a gas pressure of the principal materials is 100 Pa or larger.

In the second method of forming a silicon oxide film, since the deposition temperature is 800°C or lower and the gas pressure of the principal materials is 100 Pa or larger, it is possible to steadily suppress diffusion of an impurity, and therefore, it is possible to satisfy a standard which is usually used in manufacturing processes for manufacturing a VLSI that an effective gate length is 80% or longer of a designed gate length. Since the effective gate length is the most sensitive to an adverse effect due to impurity diffusion during VLSI manufacturing processes, if the standard requiring the effective gate length to be 80% or longer of the designed gate length is satisfied, a silicon oxide film is sufficiently appropriate as an insulating film such as an insulating film which is disposed between a control gate and a floating gate of a flash memory. Hence, it is possible to deposit a silicon oxide film while steadily suppressing diffusion of an impurity.

In the second method of forming a silicon oxide film, the deposition temperature is preferably from 780°C to 800°C and the gas pressure of the principal materials is preferably 100 Pa or larger. This makes it possible to steadily suppress diffusion of an impurity so that the effective gate length/the designed gate length becomes 80% or smaller.

In the second method of forming a silicon oxide film, alternatively, the deposition temperature is preferably from 740°C to 800°C and the gas pressure of the principal materials is preferably 125 Pa or larger. This makes it possible to steadily suppress diffusion of an impurity so that the effective gate length/the designed gate length becomes 80% or smaller.

Thus, according to the first or the second method of forming a silicon oxide film, it is possible to improve the yield of manufacturing a semiconductor device without modifying a low pressure CVD system.

A first method of manufacturing a semiconductor device according to the present invention comprises: a gate electrode forming step of forming a gate electrode on a semiconductor substrate in which an impurity-lightly-doped region is formed; a side-wall forming step of forming a side-wall of a silicon oxide film on the semiconductor substrate and at a side surface of the gate electrode; and a step of forming an impurity-heavily-doped region by implanting an impurity into the semiconductor substrate while using the gate electrode and the side-wall as a mask, wherein the side-wall forming step includes a step of forming the silicon oxide film by a low pressure CVD method in which silane gas and nitrous oxide gas are used as principal materials, under a deposition condition that a deposition temperature is 800°C or lower and a gas pressure of the principal materials is 100 Pa or larger.

In the first method of manufacturing a semiconductor device, due to an effect which is similar to that obtained in the second method of forming a silicon oxide film, it is possible to suppress diffusion of an impurity in the impurity-lightly-doped region which is formed in the semiconductor substrate during deposition of the silicon oxide film at the side-wall forming step. Hence, it is possible to improve a characteristic of a semiconductor device which has a LDD structure.

A second method of manufacturing a semiconductor device according to the present invention comprises: a wiring layer forming step of forming a wiring layer on a semiconductor substrate which is doped with an impurity; and an insulating film depositing step of depositing an insulating film of a silicon oxide film on the wiring layer, wherein the insulating film depositing step includes a step of forming the silicon oxide film by a low pressure CVD method in which silane gas and nitrous oxide gas are used as principal materials, under a deposition condition that a deposition temperature is 800°C or lower and a gas pressure of the principal materials is 100 Pa or larger.

In the second method of manufacturing a semiconductor device, due to the effect which is similar to that obtained in the second method of forming a silicon oxide film, since it is possible to suppress diffusion of an impurity which is doped in the semiconductor substrate at the step of forming the insulating film of the silicon oxide layer on the wiring layer, it is possible to improve a characteristic of the semiconductor device.

A third method of manufacturing a semiconductor device according to the present invention comprises: an insulating film depositing step of depositing an insulating film of a silicon oxide film on a semiconductor substrate which is doped with an impurity; a conductive film depositing step of depositing a conductive film on the insulating film; and an etching step of etching the conductive film using the insulating film as an etching stopper, wherein the insulating film depositing step includes a step of forming the silicon oxide film by a low pressure CVD method in which silane gas and nitrous oxide gas are used as principal materials, under a deposition condition that a deposition temperature is 800°C or lower and a gas pressure of the principal materials is 100 Pa or larger.

In the third method of manufacturing a semiconductor device, due to the effect which is similar to that obtained in the second method of forming a silicon oxide film, since it is possible to suppress diffusion of an impurity which is doped in the semiconductor substrate at the step of forming the insulating film of the silicon oxide film which serves as an etching stopper during etching of the conductive film, it is possible to improve a characteristic of the semiconductor device.

A fourth method of manufacturing a semiconductor device according to the present invention comprises: a first conductive film depositing step of depositing a first conductive film which serves as a floating gate on a semiconductor substrate which is doped with an impurity; an insulating film depositing step of depositing an insulating film of a silicon oxide film on the first conductive film; and a second conductive film depositing step of depositing a second conductive film which serves as a control gate on the insulating film, wherein the insulating film depositing step includes a step of forming the silicon oxide film by a low pressure CVD method in which silane gas and nitrous oxide gas are used as principal materials, under a deposition condition that a deposition temperature is 800°C or lower and a gas pressure of the principal materials is 100 Pa or larger.

In the fourth method of manufacturing a semiconductor device, due to the effect which is similar to that obtained in the second method of forming a silicon oxide film, it is possible to suppress diffusion of an impurity which is doped in the semiconductor substrate at the step of forming the insulating layer of the silicon oxide film which is disposed between the floating gate and the control gate. Further, when the first conductive film is made of polysilicon, since it is possible to suppress growth of particles of polysilicon during deposition of the silicon oxide film, it is possible to lessen defects in the insulating film which contacts with the first conductive film and mechanical stress which is applied upon the insulating film. Hence, it is possible to improve a characteristic of the semiconductor device such as a flash memory.

A fifth method of manufacturing a semiconductor device according to the present invention comprises: a first conductive film depositing step of depositing a first conductive film which serves as a floating gate on a semiconductor substrate which is doped with an impurity; an insulating film depositing step of depositing an insulating film of a silicon oxide film on the first conductive film; and a second conductive film depositing step of depositing a second conductive film which serves as a control gate on the insulating film, wherein the insulating film depositing step includes a step of forming the silicon oxide film by a low pressure CVD method in which silane gas and nitrous oxide gas are used as principal materials, under a deposition condition that a deposition temperature is 800°C or lower and a gas flow rate of the principal materials is 0.018 liter/min or smaller per 1 liter of capacity of a reaction chamber under a standard condition of 25°C at one atmospheric pressure.

In the fifth method of manufacturing a semiconductor device, due to the effect which is similar to that obtained in the first method of forming a silicon oxide film, it is possible to suppress a variation in the uniformness of the film thickness of the insulating film of the silicon oxide film which is disposed between the floating gate and the control gate. Hence, it is possible to improve a characteristic of the semiconductor device such as a flash memory.

A sixth method of manufacturing a semiconductor device according to the present invention comprises: an insulating film depositing step of depositing an insulating film of a silicon oxide film on an ITO substrate; and a conductive film depositing step of depositing a conductive film which serves as a source/drain region on the insulating film, wherein the insulating film depositing step includes a step of forming the silicon oxide film by a low pressure CVD method in which silane gas and nitrous oxide gas are used as principal materials, under a deposition condition that a deposition temperature is 800°C or lower and a gas pressure of the principal materials is 100 Pa or larger.

In the sixth method of manufacturing a semiconductor device, it is possible to reduce thermal damage to the ITO substrate at the step of depositing the insulating film of the silicon oxide film on the ITO substrate. Hence, it is possible to enhance a characteristic of a TFT which is formed on the ITO substrate.

### BRIEF DESCRIPTION OF THE DRAWINGS

Fig. 1 is a structure diagram of a low pressure CVD system which is used for a method of forming a silicon oxide film according to preferred embodiments of the present invention;
Fig. 2 is a view showing a relationship between a gas pressure within a reaction chamber and the uniformness of a film thickness, using a flow rate of principal material gas as a parameter;
Fig. 3 is a view showing a relationship between a deposition temperature and a deposition speed which enables an effective gate length: L_{eff} = 0.24 µm when a designed gate length:L_{design} = 0.30 µm;
Fig. 4 is a view showing a relationship between a deposition temperature and a deposition speed, using a gas pressure of principal materials as a parameter;
Figs. 5(a) to 5(c) are cross sectional views showing respective steps of a first method of manufacturing a semiconductor device according to the present invention;
Figs. 6(a) and 6(b) are cross sectional views showing the respective steps of the first method of manufacturing a semiconductor device according to the present invention;
Figs. 7(a) and 7(b) are cross sectional views showing the respective steps of the first method of manufacturing a semiconductor device according to the present invention;
Figs. 8(a) and 8(b) are cross sectional views showing respective steps of the first method of manufacturing a semiconductor device according to the present invention;
Fig. 9 is a cross sectional view showing a step of the first method of manufacturing a semiconductor device according to the present invention;
Fig. 10 is a view showing a degree of a decrease in an effective channel length in cases where an HTO film is deposited in a preferred embodiment and a comparison example, for the purpose of evaluating the present invention;
Figs. 11(a) to 11(c) are cross sectional views showing respective steps of a second method of manufacturing a semiconductor device according to the present invention;
Figs. 12(a) and 12(b) are cross sectional views showing the respective steps of the second method of manufacturing a semiconductor device according to the present invention;
Fig. 13 is a cross sectional view showing a step of the second method of manufacturing a semiconductor device according to the present invention;
Figs. 14(a) to 14(c) are cross sectional views showing respective steps of a third method of manufacturing a semiconductor device according to the present invention; and
Figs. 15(a) to 15(c) are cross sectional views showing the respective steps of the third method of manufacturing a semiconductor device according to the present invention.

### DESCRIPTION OF THE PREFERRED EMBODIMENTS

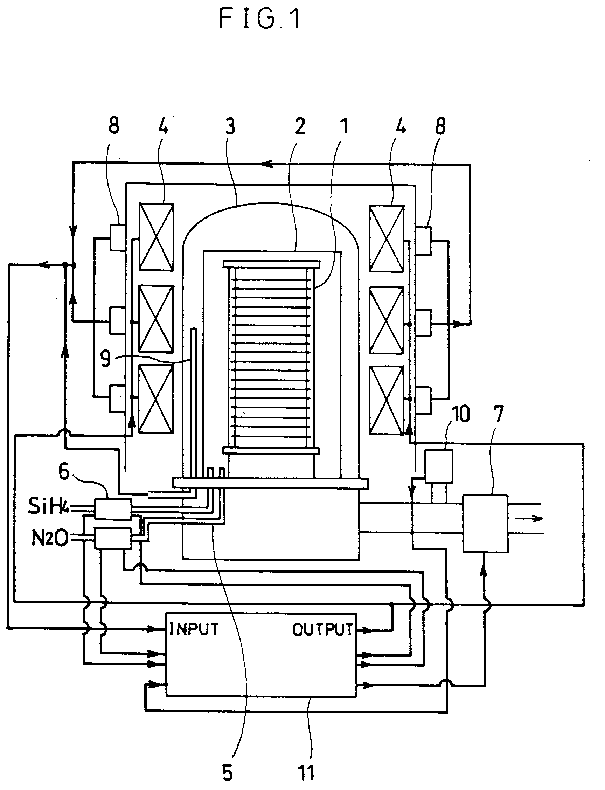

In the following, a description will be given on a low pressure CVD system which is used for a low pressure CVD method in which silane gas and nitrous oxide gas are used as principal materials, with reference to Fig. 1.

Fig. 1 shows a structure of the low pressure CVD apparatus. In Fig. 1, denoted at 1 is a wafer support board for holding a plurality of wafers in a horizontal state, denoted at 2 is an inner tube which serves as a reaction chamber for storing the wafer support board 1, denoted at 3 is an outer tube covering the inner tube 2, denoted at 4 is a heater which is disposed externally to the outer tube 3, denoted at 5 is a gas introduction pipe for introducing material gas into the inner tube 2, denoted at 6 is a mass flow controller for controlling a flow rate of gas which is introduced through the gas introduction pipe 5, denoted at 7 is exhausting means for exhausting gas or the like from the inner tube 2, denoted at 8 is an external thermocouple, denoted at 9 is an internal thermocouple, denoted at 10 is a pressure gauge, and denoted at 11 is control means.

Silane gas (SiH₄) and nitrous oxide gas (N₂O) which are used as principal material gas are introduced into the inner tube 2 through the gas introduction pipe 5, so that silicon oxide films are formed on the wafers which are held by the wafer support board 1.

The material gas within the inner tube 2 and nitrogen, vapor, hydrogen and the like which are generated during reaction are discharged outside by the exhausting means 7 through the outer tube 3.

The external thermocouple 8, the internal thermocouple 9, the pressure gauge 10 and the mass flow controller 6 measure a temperature, a gas pressure and a gas flow rate within the inner tube 2. The control means 11 compares the measurement with a set value to yield a deviation, and controls electric power to the heater 4, the exhaust volume of the exhausting means 7, the opening degree of a valve of the mass flow controller 6 and the like so that set values are maintained.

Now, a description will be given on a method of forming a silicon oxide film by a low pressure CVD method according to a first preferred embodiment of the present invention.

The first preferred embodiment is related to a method of forming a silicon oxide film by a low pressure CVD method in which silane gas and nitrous oxide gas are used as principal materials. To attain a uniform film thickness of a silicon oxide film, the first preferred embodiment sets a deposition condition for depositing a silicon oxide film so that a deposition temperature is 800°C or lower and a gas flow rate of the principal materials is 0.018 liter/min or smaller per 1 liter of capacity of a reaction chamber under a standard condition of 25°C at one atmospheric pressure.

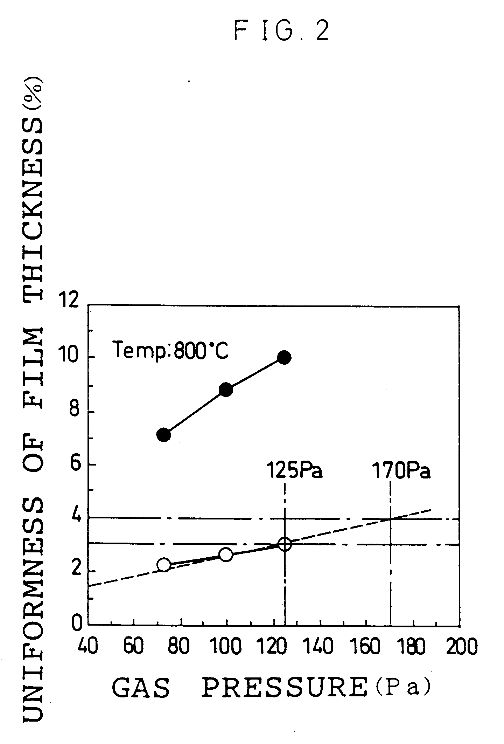

Fig. 2 shows a relationship between a gas pressure within a reaction chamber (Pa) and the uniformness of a film thickness (%), using the flow rate of the principal material gas as a parameter. In Fig. 2, ○ expresses a case where the gas flow rate of the principal material gas is 0.018 liter/min per 1 liter of capacity of a reaction chamber under the standard condition of 25°C at one atmospheric pressure, whereas ● expresses a case where the gas flow rate of the principal material gas is 0.045 liter/min per 1 liter of capacity of a reaction chamber under the standard condition of 25°C at one atmospheric pressure. In either one of the cases ○ and ●, the deposition temperature is 800°C. The uniformness of the film thickness of a silicon oxide film in a semiconductor device such as a VLSI should be within a tolerance range of 4% or smaller and is ideally 3% or smaller, as denoted by dotted lines.

As can be understood in Fig. 2, the uniformness of the film thickness deteriorates as the gas pressure decreases. This may be because particles of the principal material gas collide with each other less frequently within the reaction chamber as the gas pressure decreases.

Further, as can be understood from comparison of the solid line connecting the symbols ○ and the solid line connecting the symbols ● in Fig. 2, when the gas pressure does not change, as the flow rate of the gas increases, the uniformness of the film thickness of a silicon oxide film deteriorates. This may be because the state of the gas flowing among the wafers which are held by the wafer support board 1 shown in Fig. 1 changes from a laminar flow to a turbulent flow. That is, swirling of the gas is created among the wafers if a flow of the gas changes to a turbulent flow, and the swirling gas prevents the film thicknesses of silicon oxide films which are deposited on the wafers from becoming uniform. The deposition speed of a silicon oxide film is not very much related to a change in a gas flow rate, but is dependent upon a gas pressure and a deposition temperature.

As can be understood in Fig. 2, the uniformness of the film thickness stays within the tolerance range of 4% or smaller when the gas pressure is 170 Pa or smaller but is ideally 3% or smaller when the gas pressure is 125 Pa or smaller, if the gas flow rate of the principal material gas is 0.018 liter per 1 liter of capacity of the reaction chamber under the standard condition.

Although Fig. 2 shows a case where the deposition temperature is 800°C, since the frequency of collision between reaction products (deposits) decreases as the deposition temperature decreases, the uniformness of the film thickness is improved. Hence, when the gas flow rate is limited as described above, in a temperature region in which the deposition temperature is 800°C or lower, the uniformness of the film thickness is clearly ensured.

Now, a description will be given to a method of forming a silicon oxide film by a low pressure CVD method according to a second preferred embodiment of the present invention.

The second preferred embodiment is related to a method of forming a silicon oxide film by a low pressure CVD method in which silane gas and nitrous oxide gas are used as principal materials. To form a silicon oxide film while suppressing diffusion of an impurity, the second preferred embodiment sets a deposition condition for depositing the silicon oxide film so that a deposition temperature is 800°C or lower and a gas pressure of the principal materials is 100 Pa or smaller.

A basic policy in the second preferred embodiment is to suppress diffusion of an impurity so that a standard which is usually used in manufacturing processes for manufacturing a field effective transistor having an LDD structure that an effective gate length:L_{eff} is 80% or larger of a designed gate length: L_{design}. In manufacturing processes for manufacturing a semiconductor device such as a VLSI, a standard requiring an effective gate length of a field effective transistor having an LDD structure to be 80% or larger of a designed gate length is the severest. Therefore, if this standard is satisfied, a silicon oxide film is sufficiently appropriate as an insulating film such as an insulating film which is disposed between a control gate arid a floating gate of a flash memory.

Further, since effective gate length/designed gate length is in inverse proportion to a product of the diffusion easiness of an impurity and a deposition time, (diffusion easiness of impurity) × (deposition time) is in proportion to a diffusion volume of an impurity.

Hence, if the deposition condition for depositing a silicon oxide film is set so that L_{eff} ≧ 0.24 µm when L_{design} = 0.30 µm, it is possible to satisfy the condition for suppressing impurity diffusion which is required during VLSI manufacturing processes.

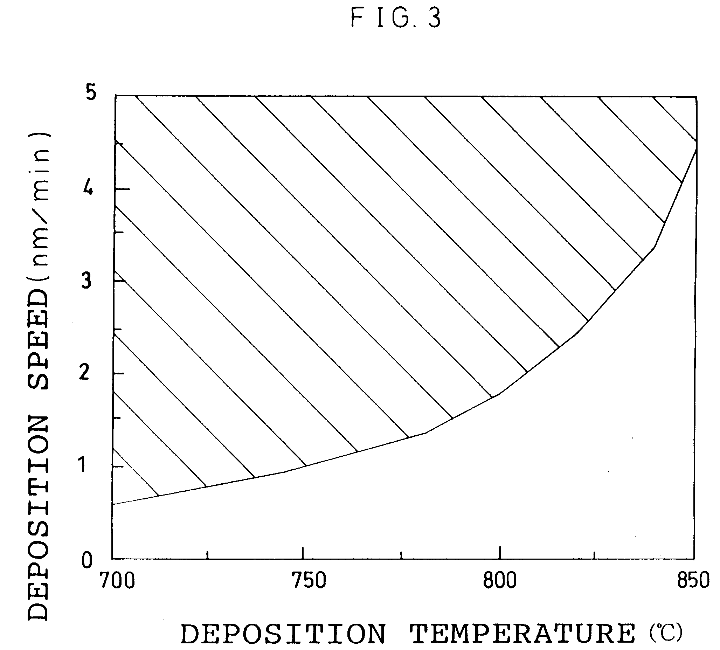

Fig. 3 shows a relationship between a deposition temperature (°C) and a deposition speed (deposition rate: nm/min) which ensures that L_{eff} = 0.24 µm when L_{design} = 0.30 µm. The hatched region is a region where L_{eff} ≧ 0.24 µm when L_{design} = 0.30 µm. If a silicon oxide film is deposited in the hatched region, an effective gate length becomes 80% or larger of a designed gate length.

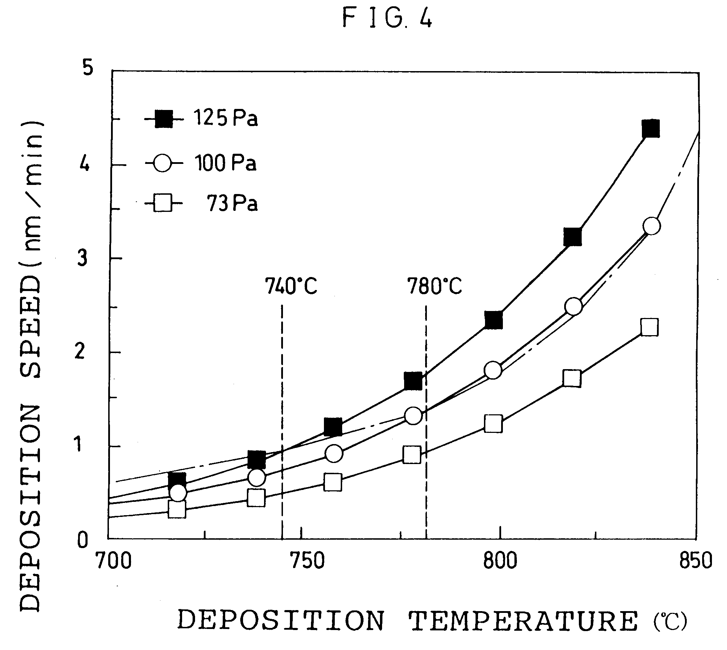

Fig. 4 shows a relationship between a deposition temperature (°C) and a deposition speed (nm/min), using a gas pressure of the principal materials as a parameter, with respect to cases where the gas pressure is 125 Pa, 100 Pa and 73 Pa. The dashed-and-dotted line in Fig. 4 corresponds to the solid line in Fig. 3. In Fig. 4, hatching is omitted for convenience of illustration.

As can be understood in Fig. 4, since the solid line connecting the symbols ○ denoting the case where the gas pressure is 100 Pa is located above and close to the dashed-and-dotted line, to ensure the effective gate length as above when the deposition temperature is 800°C or lower, it is necessary to set the gas pressure equal to or larger than 100 Pa, as a required condition. Further, since the solid line is located above the dashed-and-dotted line, i.e., in the hatched region of Fig. 3 when the deposition temperature is 780°C to 800°C and the gas pressure is 100 Pa or larger or when the deposition temperature is 740°C to 800°C and the gas pressure is 125 Pa or larger, it is always possible to ensure the effective gate length as above.

In the following, the evaluation test which was conducted to evaluate the present invention will be described. The deposition condition for a concrete example for realizing the first and the second preferred embodiments above was that the deposition temperature: 800°C, the gas pressure: 125 Pa, the flow rate of the material gas: 1 SLM (Standard Liter Minute; flow rate per 1 liter of capacity of a reaction chamber under the standard condition of 25°C at one atmospheric pressure), whereas the deposition condition for a comparison example was that the deposition temperature: 840°C, the gas pressure: 73 Pa, the flow rate of the material gas: 1 SLM.

The concrete example attained the same or faster deposition speed as that in the comparison example where the deposition temperature was 840°C, even though the deposition temperature was 800°C or lower.

Further, the numbers of dusts on HTO films deposited in the concrete and the comparison examples were measured using 6-inch sample wafers (about 130 cm²). In the both examples, there were 10 to 30 dusts of a diameter of 0.3 µm or larger. Thus, it was confirmed that the present invention does not increase the number of dusts.

In addition, the refractive indices of the HTO films deposited in the concrete and the comparison examples and etching rates of wet etching were measured. The refractive index was 1.450 to 1.455 in each example. The etching rate was defined as a difference in the film thickness of the HTO film before and after etching in a hydrofluoric solution which is diluted 20 times with ammonium fluoride at a room temperature for one minute. The etching rate was 55.5 nm/min in the comparison example, and 54.8 nm/min in the concrete example. Thus, it was confirmed that the film qualities of the HTO films were equivalent to each other in the concrete and the comparison examples.

Still further, the step coverages of the HTO films deposited in the concrete and the comparison examples were measured. The step coverage was 95 to 100% in each example. The step coverage did not deteriorate in the concrete example.

Now, a description will be given to a method of manufacturing a semiconductor device using the method of forming a silicon oxide film according to the first or the second preferred embodiment.

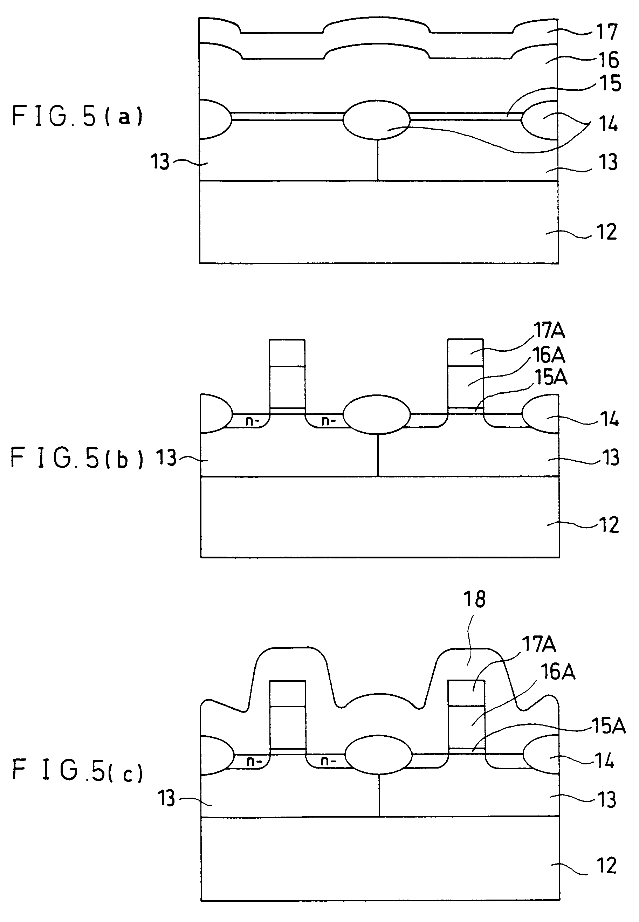

Figs. 5 to 9 show steps of a first manufacturing method of manufacturing a semiconductor device.

First, as shown in Fig. 5(a), after forming a twin well region 13, an element separation region 14 and a silicon oxide film 15 in this order on a semiconductor substrate 12, a polysilicon film is deposited on the silicon oxide film 15. Following this, trichrolide phosphate (POCl₃) gas is flowed within a diffusion furnace. After introducing phosphorus into the polysilicon film to form an N-type polysilicon film 16, a first HTO film 17 is deposited on the N-type polysilicon film 16.

Next, photolithography and dry etching are performed on the silicon oxide film 15, the N-type polysilicon film 16 and the first HTO film 17 to thereby form an under-the-gate insulating film 15A, a gate electrode 16A and an above-the-gate insulating film 17A, respectively, as shown in Fig. 5(b). Phosphorus ions are then implanted into the semiconductor substrate 12, forming an N⁻ region.

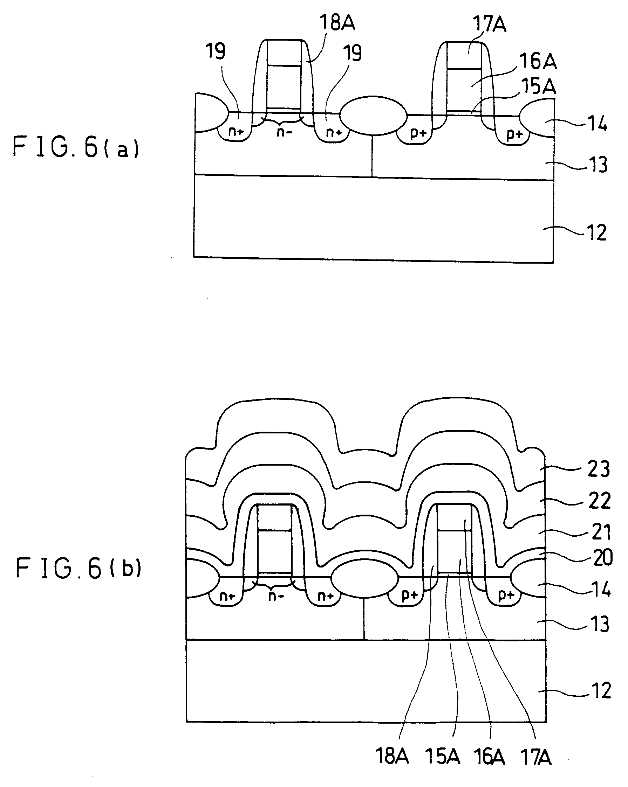

Next, after depositing a second HTO film 18 by the method of forming a silicon oxide film according to the first or the second preferred embodiment as shown in Fig. 5(c), etch back is performed on the second HTO film 18, thereby forming a gate electrode side-wall 18A as shown in Fig. 6(a). Arsenic and boron are then ion-implanted into the semiconductor substrate 12 to form a source/drain region 19.

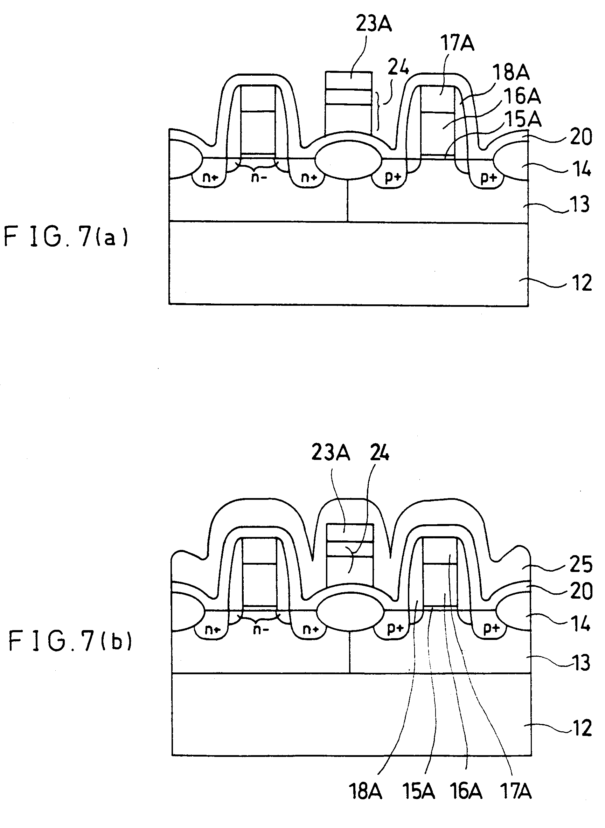

Next, as shown in Fig. 6(b), after depositing a third HTO film 20, a polysilicon film 21 into which an impurity is implanted, a tungsten silicide film 22 and a fourth HTO film 23 in this order, photolithography and dry etching are performed on the polysilicon film 21, the tungsten silicide film 22 and the fourth HTO film 23, thereby forming a polycide wire 24 which is formed by the polysilicon film 21 and the tungsten silicide film 22 and an above-the-wire insulating film 23A which is formed by the fourth HTO film 23 as shown in Fig 7(a). In this case, the third HTO film 20 and the fourth HTO film 23 are deposited by the method of forming a silicon oxide film according to the first or the second preferred embodiment.

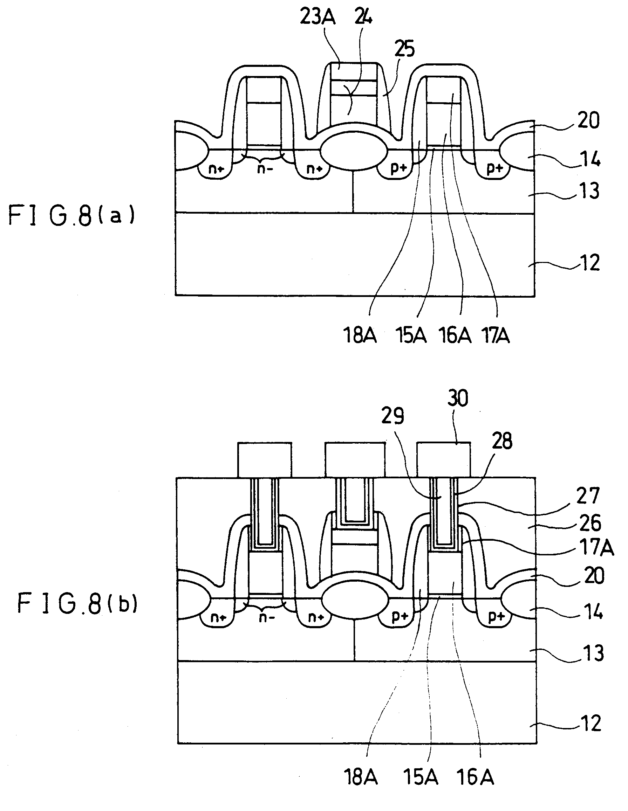

Next, after depositing a fifth HTO film 25 by the method of forming a silicon oxide film according to the first or the second preferred embodiment as shown in Fig. 7(b), etch back is performed on the fifth HTO film 25, whereby a wire side-wall 25A is formed as shown in Fig. 8(a).

Next, after forming a flattened first inter-layer insulating film 26 as shown in Fig. 8(b), a contact hole is made in the first inter-layer insulating film 26. Following this, after forming a contact by depositing titanium 27, titanium nitride 28 and tungsten 29 in this order in the contact hole, a first aluminum wire 30 is formed.

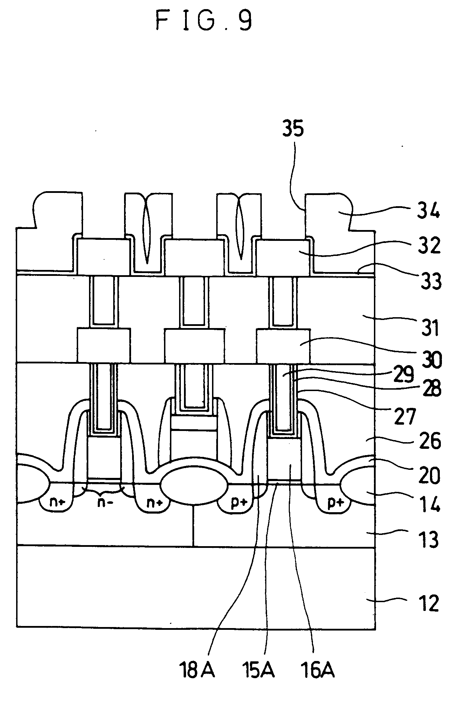

Next, after forming a flattened second inter-layer insulating film 31 as shown in Fig. 9, a contact hole is made in the second inter-layer insulating film 31. Following this, after forming a second aluminum wire 32, a phosphate glass (PSG) film 33 and a silicon nitride film 34 are deposited in this order by a plasma CVD method, whereby a passivation film is formed. An opening portion 35 for an electrode pad is thereafter formed in the phosphate glass film 33 and the silicon nitride film 34.

During deposition of the second to the fifth HTO films 18, 20, 23 and 25, the impurity within the N⁻ layer and the source/drain region 19 which are formed in the semiconductor substrate 12 is diffused in a planar direction of the substrate. This reduces the effective gate length (L_{eff}). In this case, while a short channel effect becomes remarkable and the performance of an element is deteriorated in a conventional method, in the methods according to the present invention, it is possible to suppress diffusion of the impurity since the deposition temperatures for the second to the fifth HTO films 18, 20, 23 and 25 are low, and therefore, it is possible to suppress the short channel effect.

In the first manufacturing method of manufacturing a semiconductor device, instead of the third HTO film 20 and the fifth HTO film 25, other silicide films, such as a titanium silicide film, may be deposited as protection films.

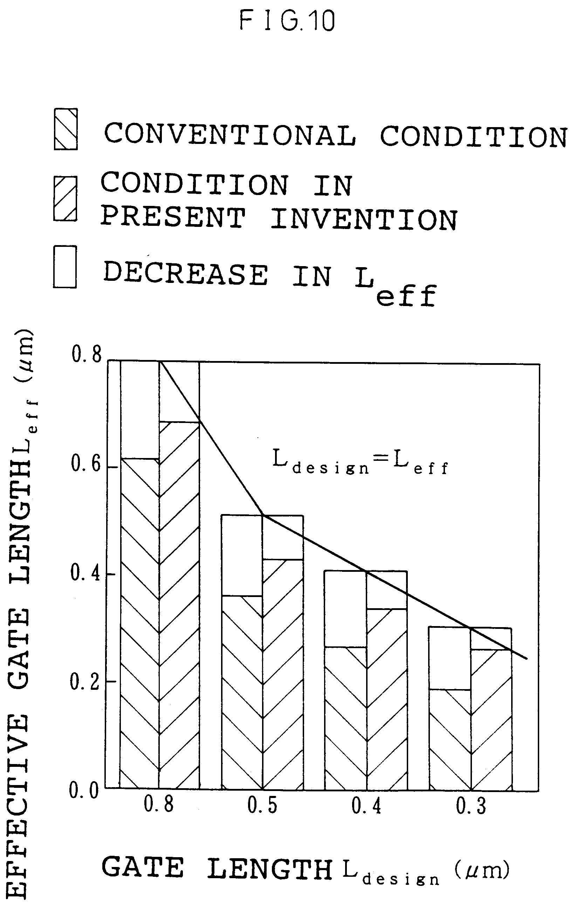

Fig. 10 shows a degree of a decrease (ΔL_{eff}) in the effective channel length in cases where an HTO film is deposited under the conditions which were used in the concrete and the comparison examples. In the cases, ΔL_{eff} = (a decrease in L_{eff} which is created during the manufacturing processes where an HTO film is deposited under the conditions used in the comparison example) - (a decrease in L_{eff} which is created during the manufacturing processes where an HTO film is deposited under the conditions used in the concrete example).

The degree of the decrease in the effective channel length: ΔL_{eff} is 0.05 to 0.10 µm in the case of an N-channel transistor, but 0.06 to 0.12 µm in the case of a P-channel transistor. Hence, it is possible to suppress a decrease in the effective channel length: L_{eff} by maximum about 0.1 µm in the case of an N-channel transistor, by maximum about 0.12 µm in the case of a P-channel transistor.

As described above, according to the first and the second preferred embodiments, the effect of preventing a decrease in the effective channel length: L_{eff} is large particularly in a transistor with a rule of 0.5 µm or smaller. Since excessive thermal diffusion of an impurity is suppressed by depositing the HTO film under the conditions used in the first and the second preferred embodiments, it is possible to improve a transistor performance and to prevent deterioration in an element separating characteristic.

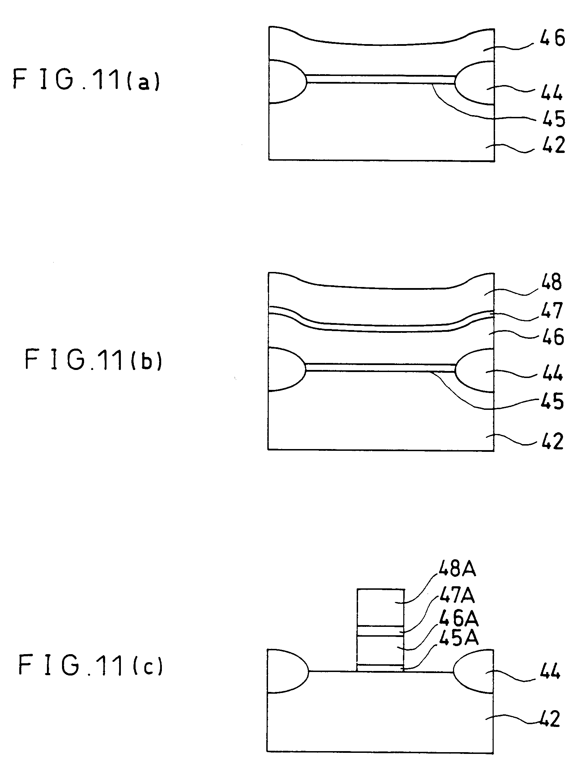

Figs. 11 to 13 show steps of a second manufacturing method of manufacturing a semiconductor device which is formed by a flash EEPROM (Electrical Erasable Programmable Read Only Memory).

First, as shown in Fig. 11(a), after forming an element separation region 44 and a silicon oxide film 45 on a semiconductor substrate 42 in this order, a polysilicon film is deposited on the silicon oxide film 45. Following this, trichrolide phosphate (POCl₃) gas is flowed within a diffusion furnace to introduce phosphorus into the polysilicon film, whereby a first N-type polysilicon film 46 is formed.

Next, after forming a first HTO film 47 with a thickness of 10 to 25 nm on the first N-type polysilicon film 46 by the method of forming a silicon oxide film according to the first or the second preferred embodiment as shown in Fig. 11(b), a second N-type polysilicon film 48 which is doped with phosphorus is deposited on the first HTO film 47.

Next, as shown in Fig. 11(c), photolithography and dry etching are performed on the first HTO film 47 and the second N-type polysilicon film 48, to thereby form an under-the-gate insulating film 45A, a floating gate electrode 46A, an inter-gate insulating film 47A and a control gate electrode 48A.

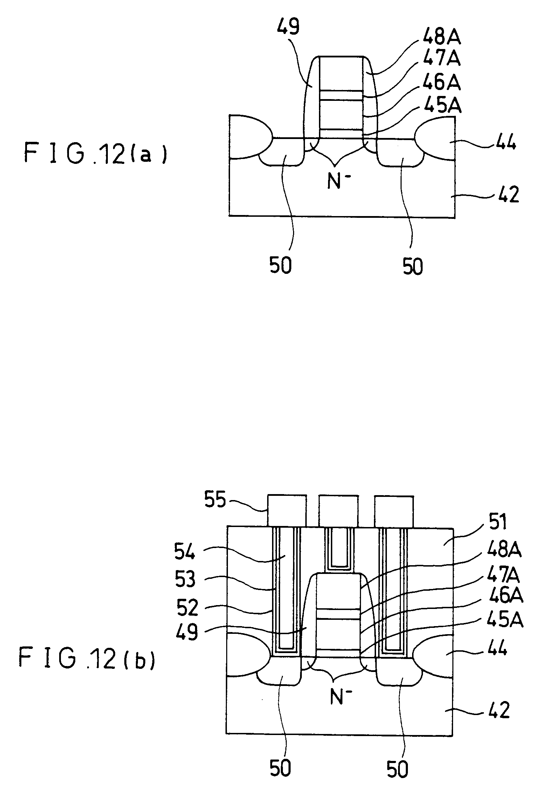

Next, as shown in Fig. 12(a), phosphorus is ion-implanted into the semiconductor substrate 42 to form an N⁻ region. Following this, after depositing a second HTO film by the method of forming a silicon oxide film according to the first or the second preferred embodiment, etch back is performed on the second HTO film to form a gate electrode side-wall 49. Arsenic and boron are then ion-implanted into the semiconductor substrate 42 to form a source/drain region 50.

Next, after forming a flattened first inter-layer insulating film 51 as shown in Fig. 12(b), a contact hole is made in the first inter-layer insulating film 51. Following this, after forming a contact by depositing titanium 52, titanium nitride 53 and tungsten 54 in this order in the contact hole, a first aluminum wire 55 is formed.

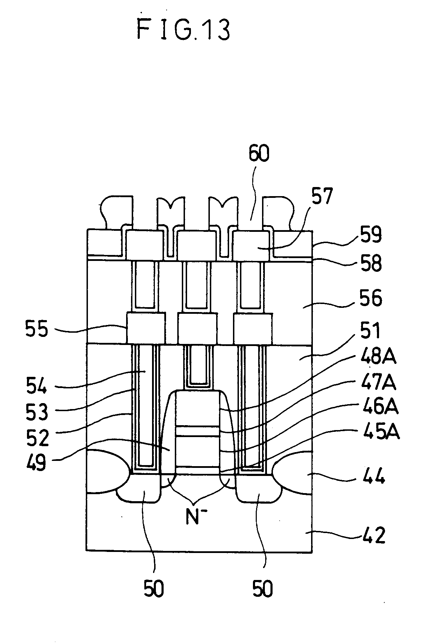

Next, after forming a flattened second inter-layer insulating film 56 as shown in Fig. 13, a contact hole is made in the second inter-layer insulating film 56. Following this, after forming a second aluminum wire 57, a phosphate glass (PSG) film 58 and a silicon nitride film 59 are deposited in this order by a plasma CVD method, whereby a passivation film is formed. An opening portion 60 for an electrode pad is thereafter formed in the phosphate glass film 58 and the silicon nitride film 59.

Since a gas flow rate for depositing the first HTO film 47 is small and therefore the film thickness of the inter-gate insulating film 47A becomes uniform, it is possible to reduce a variation in the performance of the flash EEPROM. Further, since a deposition temperature of the second HTO film which becomes the gate electrode side wall 49 is low, it is possible to suppress diffusion of the impurity within the N⁻ layer and the source/drain region 50, to suppress excessive growth of particles in the control gate electrode 46A, and to reduce defects which is generated in the inter-gate insulating film 47A and mechanical stress upon the under-the-gate insulating film 45A.

Further, since an interface state density is reduced and leak between gate electrodes is prevented as compared with a case where a silicon nitride film or the like is formed on the first N-type polysilicon film 46, a data holding characteristic does not deteriorate.

In the second method of manufacturing a semiconductor device above, if an ONO (Oxide-Nitride-Oxide) film is used instead of the silicon oxide film 45 which serves as the under-the-gate insulating film 45A, the reliability of an element and the data holding characteristic are further improved.

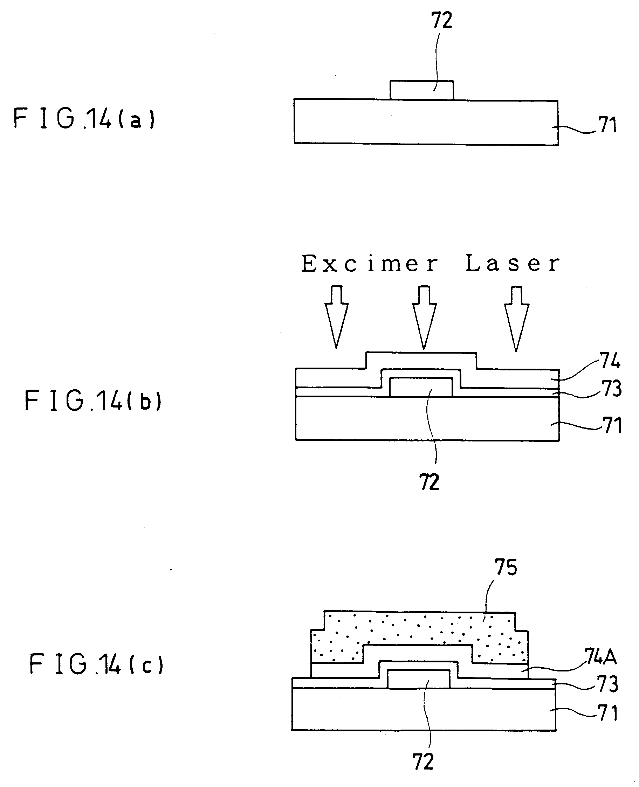

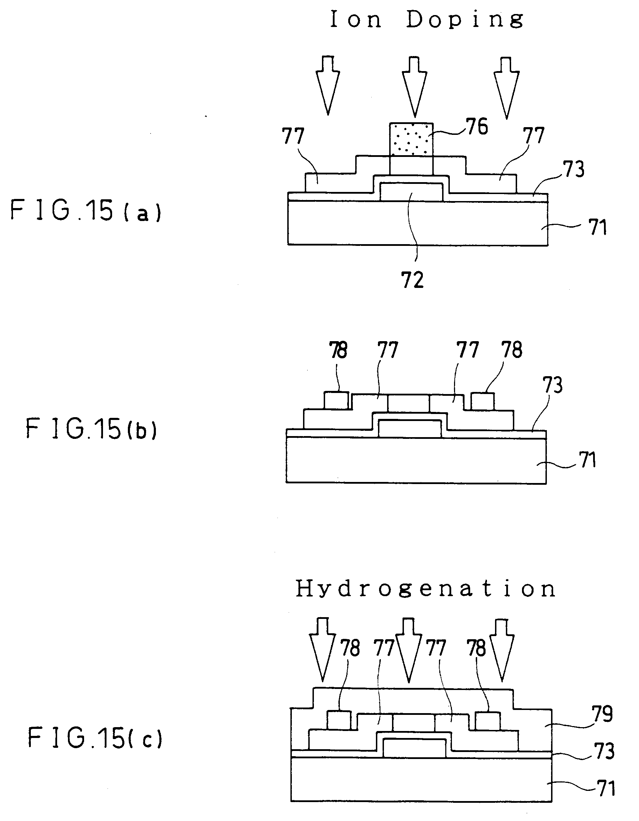

Figs. 14 and 15 show steps of a third manufacturing method of manufacturing a semiconductor device which is formed by a TFT (Thin Film Transistor).

First, as shown in Fig. 14(a), a gate electrode 72 which is formed by polysilicon which is doped with high fusing point metal or an N-type impurity is formed on an ITO substrate 71.

Next, as shown in Fig. 14(b), an HTO film 73 is deposited by the method of forming a silicon oxide film according to the first or the second preferred embodiment. Following this, after depositing an amorphous silicon film on the HTO film 73, a polysilicon film 74 having a particle diameter of a few µm or larger is formed on the amorphous silicon film by irradiation of an excimer laser.

Next, after forming a first resist pattern 75 on the polysilicon film 74 as shown in Fig. 14(c), the polysilicon film 74 is patterned by dry etching, whereby a patterned polysilicon film 74A is formed.

Next, after forming a second resist pattern 76 on the patterned polysilicon film 74A as shown in Fig. 15(a), ions are implanted into the patterned polysilicon film 74A using the second resist pattern 76 as a mask, to thereby form a source/drain region 77.

Next, after depositing a metal film over the entire surface as shown in Fig. 15(b), the metal film is patterned to form a source/drain electrode 78.

Next, after depositing a first passivation film 79 over the entire surface as shown in Fig. 15(c), a hydrogeneration treatment is performed on the passivation film 79.

Next, after forming a contact in the first passivation film 79, an aluminum wire to be connected with the contact is formed. Following this, after forming a second passivation film, an opening portion is formed in the second passivation film.

In the third manufacturing method of manufacturing a semiconductor device, since the HTO film 73 is deposited by the methods of forming a silicon oxide film according to the first and the second preferred embodiments, it is possible to suppress a variation in the film thickness of the HTO film 73, and therefore, to stabilize a gate current and reduce thermal damage to the ITO substrate 71. This makes it possible to manufacture a TFT of an excellent quality at a good yield.

## Claims

1. A method of forming a silicon oxide film comprising a silicon oxide film depositing step of depositing a silicon oxide film by a low pressure CVD method in which silane gas and nitrous oxide gas are used as principal materials, wherein said silicon oxide film depositing step is performed under a deposition condition that a deposition temperature is 800°C or lower and a gas flow rate of said principal materials is 0.018 liter/min or smaller per 1 liter of capacity of a reaction chamber under a standard condition of 25°C at one atmospheric pressure.

2. The method of forming a silicon oxide film of Claim 1, wherein said deposition condition includes a condition that a gas pressure of said principal materials is 170 Pa or smaller.

3. The method of forming a silicon oxide film of Claim 1, wherein said deposition condition includes a condition that a gas pressure of said principal materials is 125 Pa or smaller.

4. A method of forming a silicon oxide film comprising a silicon oxide film depositing step of depositing a silicon oxide film by a low pressure CVD method in which silane gas and nitrous oxide gas are used as principal materials, wherein said silicon oxide film depositing step is performed under a deposition condition that a deposition temperature is 800°C or lower and a gas pressure of said principal materials is 100 Pa or larger.

5. The method of forming a silicon oxide film of Claim 4, wherein said deposition temperature is from 780°C to 800°C and a gas pressure of said principal materials is 100 Pa or larger.

6. The method of forming a silicon oxide film of Claim 4, wherein said deposition temperature is from 780°C to 800°C and a gas pressure of said principal materials is 125 Pa or larger.

7. A method of manufacturing a semiconductor device comprising:
a gate electrode forming step of forming a gate electrode on a semiconductor substrate in which an impurity-lightly-doped region is formed;
a side-wall forming step of forming a side-wall of a silicon oxide film on said semiconductor substrate and at a side surface of said gate electrode; and
a step of forming an impurity-heavily-doped region by implanting an impurity into said semiconductor substrate while using said gate electrode and said side wall as a mask,
wherein said side-wall forming step includes a step of forming said silicon oxide film by a low pressure CVD method in which silane gas and nitrous oxide gas are used as principal materials, under a deposition condition that a deposition temperature is 800°C or lower and a gas pressure of said principal materials is 100 Pa or larger.

8. A method of manufacturing a semiconductor device comprising:
a wiring layer forming step of forming a wiring layer on a semiconductor substrate which is doped with an impurity; and
an insulating film depositing step of depositing an insulating film of a silicon oxide film on said wiring layer,
wherein said insulating film depositing step includes a step of forming said silicon oxide film by a low pressure CVD method in which silane gas and nitrous oxide gas are used as principal materials, under a deposition condition that a deposition temperature is 800°C or lower and a gas pressure of said principal materials is 100 Pa or larger.

9. A method of manufacturing a semiconductor device comprising:
an insulating film depositing step of depositing an insulating film of a silicon oxide film on a semiconductor substrate which is doped with an impurity;
a conductive film depositing step of depositing a conductive film on said insulating film; and
an etching step of etching said conductive film using said insulating film as an etching stopper,
wherein said insulating film depositing step includes a step of forming said silicon oxide film by a low pressure CVD method in which silane gas and nitrous oxide gas are used as principal materials, under a deposition condition that a deposition temperature is 800°C or lower and a gas pressure of said principal materials is 100 Pa or larger.

10. A method of manufacturing a semiconductor device comprising:
a first conductive film depositing step of depositing a first conductive film which serves as a floating gate on a semiconductor substrate which is doped with an impurity;
an insulating film depositing step of depositing an insulating film of a silicon oxide film on said first conductive film; and
a second conductive film depositing step of depositing a second conductive film which serves as a control gate on said insulating film,
wherein said insulating film depositing step includes a step of forming the silicon oxide film by a low pressure CVD method in which silane gas and nitrous oxide gas are used as principal materials, under a deposition condition that a deposition temperature is 800°C or lower and a gas pressure of said principal materials is 100 Pa or larger.

11. A method of manufacturing a semiconductor device comprising:
a first conductive film depositing step of depositing a first conductive film which serves as a floating gate on a semiconductor substrate which is doped with an impurity;
an insulating film depositing step of depositing an insulating film of a silicon oxide film on said first conductive film; and
a second conductive film depositing step of depositing a second conductive film which serves as a control gate on said insulating film,
wherein said insulating film depositing step includes a step of forming said silicon oxide film by a low pressure CVD method in which silane gas and nitrous oxide gas are used as principal materials, under a deposition condition that a deposition temperature is 800°C or lower and a gas flow rate of said principal materials is 0.018 liter/min or smaller per 1 liter of capacity of a reaction chamber under a standard condition of 25°C at one atmospheric pressure.

12. A method of manufacturing a semiconductor device comprising:
an insulating film depositing step of depositing an insulating film of a silicon oxide film on an ITO substrate; and
a conductive film depositing step of depositing a conductive film which serves as a source/drain region on said insulating film,
wherein said insulating film depositing step includes a step of forming said silicon oxide film by a low pressure CVD method in which silane gas and nitrous oxide gas are used as principal materials, under a deposition condition that a deposition temperature is 800°C or lower and a gas pressure of said principal materials is 100 Pa or larger.
